# EUROPEAN PATENT APPLICATION

(11) **EP 4 539 336 A1**
(43) Date of publication of application: **16.04.2025**
(21) Application number: 23829426.8
(22) Date of filing: 22.02.2023
(51) Int. Cl.: H03F 1/32, G06N 3/04

(54) **IMPLEMENTATION METHOD FOR DIGITAL PREDISTORTION SOLUTION OR DIGITAL PREDISTORTION HARDWARE STRUCTURE, AND DEVICE AND MEDIUM**

(30) Priority: 01.07.2022 CN 202210775374
(71) Applicant: ZTE Corporation, Shenzhen, Guangdong 518057 (CN)
(72) Inventor: LIU, Lei, Shenzhen, Guangdong 518057 (CN); FANG, Yisheng, Shenzhen, Guangdong 518057 (CN)
(74) Representative: Aipex B.V.
(86) International application number: PCT/CN2023/077672
(87) International publication number: WO 2024/001233

(57) **Abstract**

Provided is a method for implementing a digital predistortion scheme. The method includes obtaining (S210) artificial-intelligence-digital-predistortion (AI-DPD) schemes of eight neural-networks by using a unified digital predistortion (DPD) hardware structure and using software configuration.

## Description

### TECHNICAL FIELD

The present application relates to the field of communications, particularly a digital predistortion scheme or hardware structure implementation method, a device, and a medium.

### BACKGROUND

A power amplifier is one of the key devices that impact signal coverage and signal quality in a wireless communication system. It has long been a desired goal to linearize its nonlinear characteristics. Ultra-wideband (a bandwidth exceeding 200 MHz) power amplifiers (UWB PAs) exhibit complex dynamic nonlinear characteristics across multiple dimensions including (average) power, (drain) voltage, (center) frequency, temperature, and different materials (semiconductor devices). The artificial-intelligence-digital-predistortion (AI-DPD) technology in the related art faces significant challenges in adapting to various PA characteristics by using only a particular neural network structure.

### SUMMARY

In view of this, embodiments of the present application provide a digital predistortion scheme or hardware structure implementation method, a device, and a medium, achieving digital predistortion at the cost of minimum hardware overhead by providing AI-DPD schemes of various neural-networks by using flexible software configuration.

An embodiment of the present application provides a method for implementing a digital predistortion scheme. The method includes obtaining artificial-intelligence-digital-predistortion schemes of eight neural-networks by using a unified digital predistortion (DPD) hardware structure and using software configuration.

An embodiment of the present application provides a digital predistortion hardware structure implementation method. The method includes prebuilding a unified digital predistortion hardware structure. The unified digital predistortion hardware structure is configured to implement artificial-intelligence-digital-predistortion.

An embodiment of the present application provides a method for implementing a digital predistortion scheme. The method includes obtaining artificial-intelligence-digital-predistortion schemes of eight neural-networks by using software configuration.

An embodiment of the present application provides a device. The device includes a memory and at least one processor.

The memory is configured to store at least one program.

The at least one processor is configured to perform the method of any previous embodiment when executing the at least one program.

An embodiment of the present application provides a storage medium storing a computer program which, when executed by a processor, causes the processor to perform the method of any previous embodiment.

### BRIEF DESCRIPTION OF DRAWINGS

FIG. 1 is a diagram illustrating AI-DPD in a power amplifier system according to an embodiment of the present application.
FIG. 2 is a flowchart of a method for implementing a digital predistortion scheme according to an embodiment of the present application.
FIG. 3 is a flowchart of a digital predistortion hardware structure implementation method according to an embodiment of the present application.
FIG. 4 is a flowchart of a method for implementing a digital predistortion scheme according to an embodiment of the present application.
FIG. 5 is a diagram illustrating the structure of a unified digital predistortion hardware structure according to an embodiment of the present application.
FIG. 6 is a configuration diagram of processing symbol tags in a unified digital predistortion hardware structure according to an embodiment of the present application.
FIG. 7 is a diagram illustrating the structure of complex pointwise addition according to an embodiment of the present application.
FIG. 8 is a diagram illustrating the structure of full connection according to an embodiment of the present application.
FIG. 9 is a diagram illustrating the structure of complex inner product according to an embodiment of the present application.
FIG. 10 is a diagram illustrating configuration of eight neural networks by using software according to an embodiment of the present application.
FIG. 11 is a diagram of a neural network structure equivalent to a unified digital predistortion hardware structure that has undergone software configuration according to an embodiment of the present application.
FIG. 12 is a diagram of a neural network structure equivalent to a unified digital predistortion hardware structure that has undergone software configuration according to an embodiment of the present application.
FIG. 13 is a diagram of a neural network structure equivalent to a unified digital predistortion hardware structure that has undergone software configuration according to an embodiment of the present application.
FIG. 14 is a diagram of a neural network structure equivalent to a unified digital predistortion hardware structure that has undergone software configuration according to an embodiment of the present application.
FIG. 15 is a diagram illustrating test performance comparison between eight neural networks obtained by software configuration on a unified digital predistortion hardware structure according to an embodiment of the present application.
FIG. 16 is a block diagram of a digital predistortion scheme implementation apparatus according to an embodiment of the present application.
FIG. 17 is a block diagram of a digital predistortion hardware structure implementation apparatus according to an embodiment of the present application.
FIG. 18 is a block diagram of a digital predistortion scheme implementation apparatus according to an embodiment of the present application.
FIG. 19 is a diagram illustrating the structure of a power amplifier device according to an embodiment of the present application.

### DETAILED DESCRIPTION

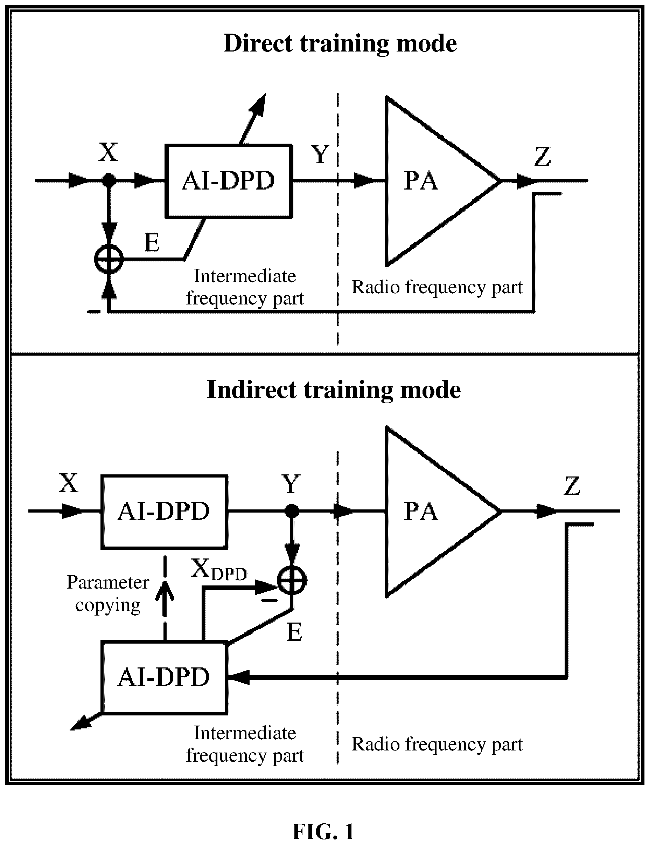

The AI-DPD scheme of embodiments of the present application may be configured in a power amplifier system. FIG. 1 is a diagram illustrating AI-DPD in a power amplifier system according to an embodiment of the present application. As shown in FIG. 1, AI-DPD involves two training modes: direct training mode and indirect training mode.

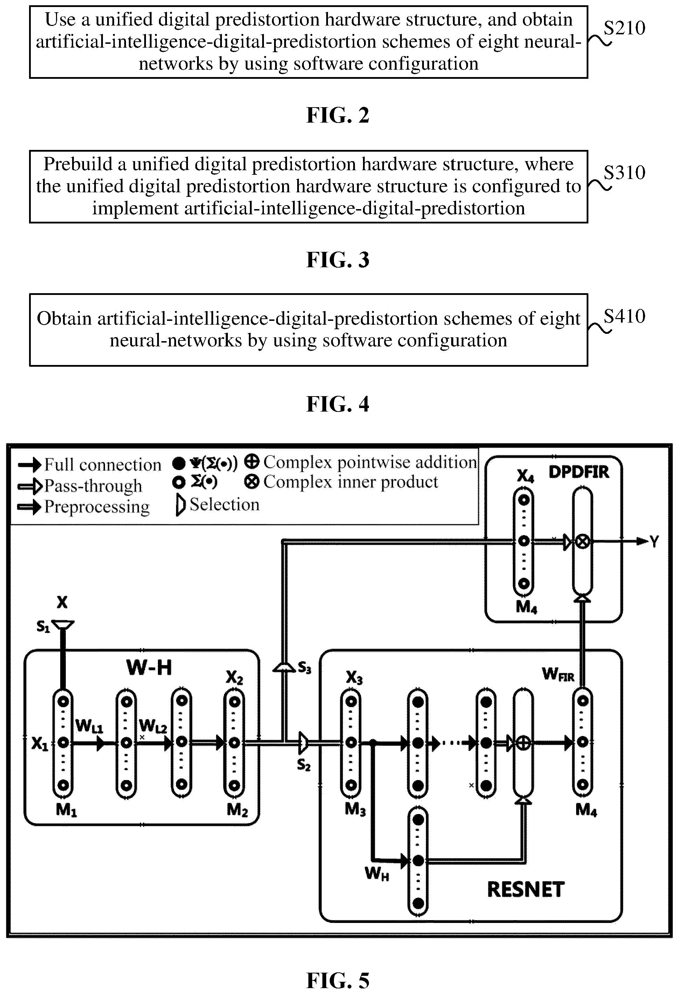

FIG. 2 is a flowchart of a method for implementing a digital predistortion scheme according to an embodiment of the present application. This embodiment may be performed by a device. The device may be, for example, a power amplifier system. As shown in FIG. 2, this embodiment includes S210.

In S210, artificial-intelligence-digital-predistortion schemes of eight neural-networks are obtained by using a unified digital predistortion hardware structure and using software configuration.

In an embodiment, based on a neural-network-based intermediate-frequency digital predistortion scheme, artificial-intelligence-digital-predistortion schemes of multiple neural-networks are obtained by using a unified digital predistortion hardware structure and using software configuration, thereby achieving digital predistortion at the cost of minimum hardware overhead by providing AI-DPD schemes of various neural-networks by using flexible software configuration.

FIG. 3 is a flowchart of a digital predistortion hardware structure implementation method according to an embodiment of the present application. This embodiment may be implemented by a power amplifier device. As shown in FIG. 3, this embodiment includes S310.

In S310, a unified digital predistortion hardware structure is prebuilt. The unified digital predistortion hardware structure is configured to implement artificial-intelligence-digital-predistortion.

In this embodiment, the unified digital predistortion hardware structure is prebuilt for AI-DPD.

FIG. 4 is a flowchart of a method for implementing a digital predistortion scheme according to an embodiment of the present application. This embodiment may be performed by a device. The device may be, for example, a power amplifier system. As shown in FIG. 4, this embodiment includes S410.

In S410, artificial-intelligence-digital-predistortion schemes of eight neural-networks are obtained by using software configuration.

In an embodiment, eight neural networks are obtained by using software configuration and then are combined with a predistortion filter (DPDFIR module) scheme to form an AI-DPD scheme, thereby achieving digital predistortion at the cost of minimum hardware overhead by providing AI-DPD schemes of various neural-networks by using flexible software configuration.

FIG. 5 is a diagram illustrating the structure of a unified digital predistortion hardware structure according to an embodiment of the present application. In this embodiment, neural networks obtainable by software configuration on the unified digital predistortion hardware structure are in the following four types:

The first type is [WHRESNET], that is, a neural network that starts with a Wiener-Hammerstein filter module (W-H module) followed by a residual network (RESNET module). A typical W-H module structure can be equivalent to a fully connected network having two hidden layers. As shown in FIG. 5, the hidden and output layers of the W-H module perform only linear weighted summation without nonlinear activation processing.

The second type is [WHDNN], this is, a neural network that starts with a W-H module followed by a fully connected network (deep neural network (DNN) module).

The third type is [RESNET], that is, a neural network whose hop link first undergoes a fully connected layer and then skips across multiple layers to undergo complex pointwise addition with a subsequent layer, not a traditional residual network structure.

The fourth type is [DNN], that is, a neural network having multiple layers where each layer is fully connected to the adjacent layers.

As shown in FIG. 5, the unified digital predistortion hardware structure of this embodiment includes a WH module, a residual network module, and a digital predistortion filter module.

The output of the WH module is connected to the input of the residual network module and the input of the digital predistortion filter module. The output of the residual network module is connected to the input of the digital predistortion filter module.

In an embodiment, the WH module is equivalent to a fully connected network having two hidden layers, a hot link in the residual network module first undergoes a fully connected layer and then skips across multiple layers to undergo complex pointwise addition with subsequent layers, and the filter coefficient of the digital predistortion filter module is provided by the residual network module.

In an embodiment, the WH module includes an input layer, a first hidden layer, a second hidden layer, and an output layer. The input layer is fully connected to the first hidden layer. The first hidden layer is fully connected to the second hidden layer. Preprocessing is performed between the second hidden layer and the output layer.

The WH module is configured to filter and preprocess an input signal vector and feed the preprocessed signal vector into the residual network module and the digital predistortion filter module separately.

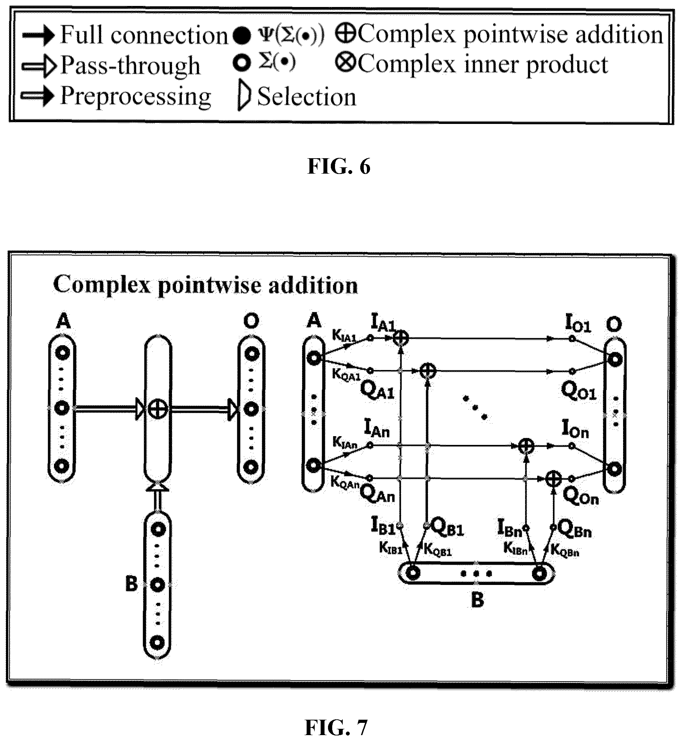

FIG. 6 is a configuration diagram of processing symbol tags in a unified digital predistortion hardware structure according to an embodiment of the present application. In this embodiment, the unified digital predistortion hardware structure includes various processing symbols as shown in FIG. 6. The tags of the processing symbols include, but are not limited to, full connection, bypass, preprocessing, complex pointwise addition, complex inner product, selection, weighting, and summing.

In an embodiment, the preprocessing includes at least one of the following: taking a real part and an imaginary part of a complex vector to form a real part vector and an imaginary part vector respectively, taking a magnitude of a complex vector to form a magnitude vector, taking a conjugate of a complex vector to form a conjugate vector, concatenating a complex vector and a magnitude vector to form a concatenated vector, or concatenating a complex vector and a conjugate vector to form a concatenated vector.

In an embodiment, the residual network module includes an input layer, at least two hidden layers, and an output layer.

The at least two hidden layers are fully connected to each other and undergo complex pointwise addition to obtain a filter coefficient vector.

In an embodiment, the residual network module also includes a hidden layer of the hot link.

The hidden layer of the hot link undergoes full connection and undergoes complex pointwise addition with the last hidden layer of at least two hidden layers to obtain a filter coefficient vector.

In an embodiment, the complex pointwise addition includes at least real part component vectors and imaginary part component vectors of two complex operation vectors.

Weighted vectors of the real part component vectors of the two complex operation vectors include an all-one matrix.

Weighted vectors of the imaginary part component vectors of the two complex operation vectors include one of an all-one matrix or an all-zero matrix.

FIG. 7 is a diagram illustrating the structure of complex pointwise addition according to an embodiment of the present application. Complex pointwise addition refers to elementwise addition between complex vectors of equal length. As shown in FIG. 7, *K̅_{I̅_{A}}*, *K̅_{I̅_{B}},* *̅K̅*̅_{Q̅_{A}}, and *̅K̅*̅_{Q̅B} are weighted vectors of the real part component vectors (*I̅_{A}* and *I̅_{B})* of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

In an embodiment, the full connection includes at least a real part component and an imaginary part component vector of an input vector of a connection edge and a real part component and an imaginary part component vector of an edge weight vector.

The weighted vector of the real part component includes an all-one matrix. The weighted vector of the imaginary part component vector includes one of an all-one matrix or an all-zero matrix.

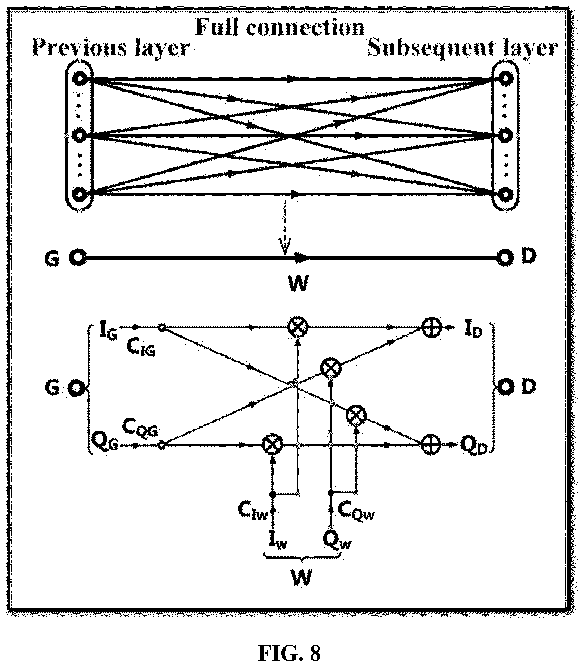

FIG. 8 is a diagram illustrating the structure of full connection according to an embodiment of the present application. The tag of full connection refers to complex full connection processing between neurons in the previous layer and neurons in the subsequent layer. The structure involved is shown in FIG. 8. *C̅_{I̅_{G}}* , *C̅_{I̅_{W}}, C̅_{Q̅_{G}},* and *C̅_{Q̅_{W}}* are weighted vectors of the real part component vectors (*I̅_{G}* and *I̅_{W}*) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

In an embodiment, the digital predistortion filter module includes an input layer and a complex inner product layer.

A signal vector input to the input layer and a filter coefficient vector provided by the residual network module are processed in the complex inner product layer to obtain a digitally predistorted filtered signal scalar.

In an embodiment, the complex inner product of the digital predistortion filter module includes at least real part component vectors and imaginary part component vectors of two complex operation vectors.

Weighted vectors of the real part component vectors of the two complex operation vectors include an all-one matrix.

Weighted vectors of the imaginary part component vectors of the two complex operation vectors include one of an all-one matrix or an all-zero matrix.

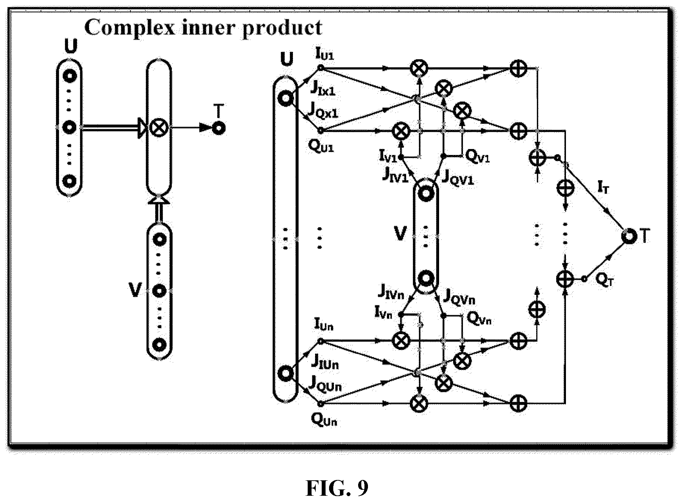

FIG. 9 is a diagram illustrating the structure of complex inner product according to an embodiment of the present application. The complex inner product refers to the mathematical description of predistortion filtering. The structure involved is shown in FIG. 9. *J̅_{I̅U}*, *J̅_{I̅V}*, *J̅_{Q̅V}*, and *J̅_{Q̅V}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

In an embodiment, obtaining the AI-DPD schemes of eight neural-networks by using the software configuration includes obtaining the AI-DPD schemes of the following eight neural-networks by using the software configuration: a complex WH residual network, a real WH residual network, a complex WH deep neural network, a real WH deep neural network, a complex residual network, a real residual network, a complex deep neural network, and a real deep neural network.

In an embodiment, obtaining the AI-DPD schemes of eight neural-networks by using the software configuration includes obtaining the AI-DPD schemes of eight neural-networks by reconfiguring a fully connected weight matrix between an input layer of a WH module and a first hidden layer of the WH module and a fully connected weight matrix between the first hidden layer of the WH module and a second hidden layer of the WH module and reconfiguring a fully connected weight matrix of a hot link in a residual network module by using the software configuration.

In an embodiment, as shown in FIG. 5, the fully connected weight matrix between the input layer and the first hidden layer is represented by W_{L1}, the fully connected weight matrix between the first hidden layer and the second hidden layer is represented by W_{L2}, and the fully connected weight matrix of a hot link in the residual network module is represented by W_{L}. It is to be understood that eight different neural network structures may be obtained through parameter configuration for W_{L1}, W_{L2}, and WH and then combined with the DPDFIR module to form eight different AI-DPD schemes.

In an embodiment, the fully connected weight matrix between the input layer and the first hidden layer and the fully connected weight matrix between the first hidden layer and the second hidden layer are configured in one of the following manners: identity matrix, random initialization, historical training weight initialization, or other constant weight initialization.

In an embodiment, the fully connected weight matrix of the hot link in the residual network module are configured in one of the following manners: all-zero matrix, random initialization, historical training weight initialization, or other constant weight initialization.

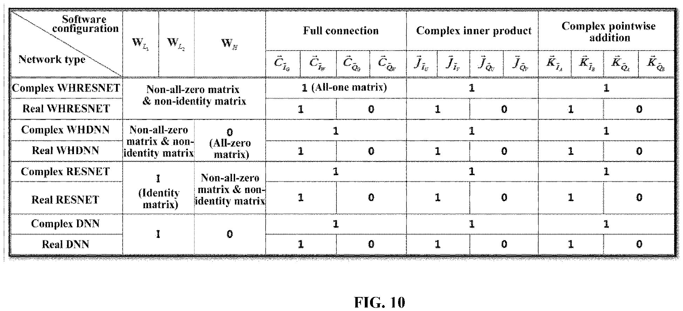

FIG. 10 is a diagram illustrating configuration of eight neural networks by using software according to an embodiment of the present application. As shown in FIG. 10, eight neural networks including complex neural networks and real neural networks may be obtained by using software configuration based on the preceding four neural networks. The eight neural networks are the complex WHRESNET network whose software configuration is as shown in the first row of FIG. 10, the real WHRESNET network whose software configuration is as shown in the second row of FIG. 10, the complex WHDNN network whose software configuration is as shown in the third row of FIG. 10, the real WHDNN network whose software configuration is as shown in the fourth row of FIG. 10, the complex RESNET network whose software configuration is as shown in the fifth row of FIG. 10, the real RESNET network whose software configuration is as shown in the sixth row of FIG. 10, the complex DNN network whose software configuration is as shown in the seventh row of FIG. 10, and the real DNN network whose software configuration is as shown in the eighth row of FIG. 10.

Complex neural networks and real neural networks differ in three aspects:
1. The data type of all network parameters (weight W and bias): Parameters in complex neural networks are typically complex numbers while parameters in real neural networks are typically real numbers.
2. Neural activation function: Neural activation functions in complex neural networks are complex functions while neural activation functions in real neural networks are real functions.
3. Training algorithms of the neural networks: Complex neural networks use complex backpropagation algorithms (complex BP) while real neural networks use real backpropagation algorithms (real BP). The two are not simply the same algorithm with complex numbers replacing real numbers; they have significant differences in their gradient computation formulas.

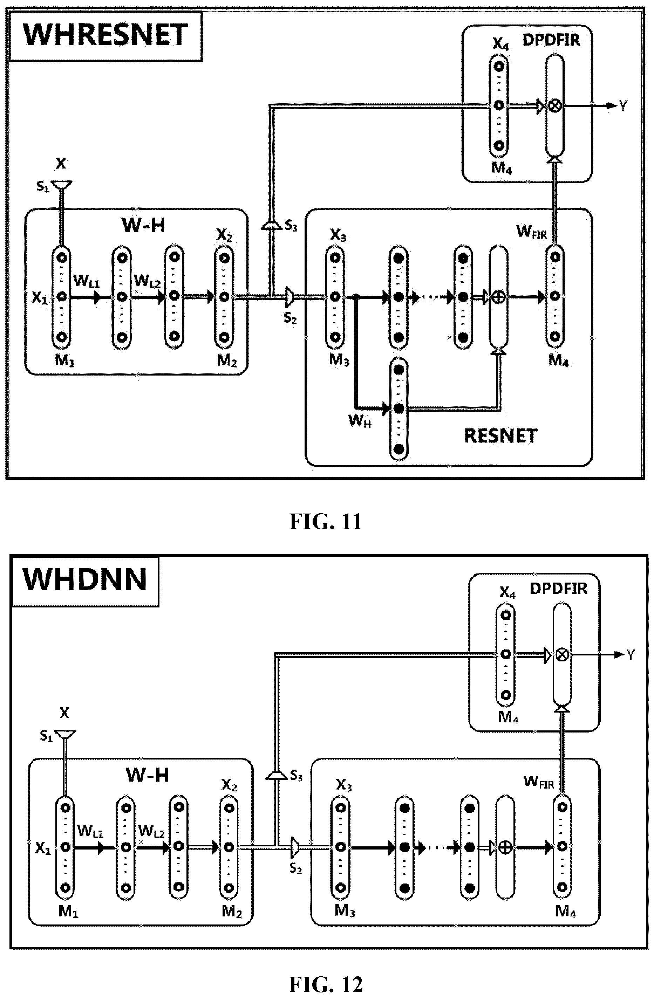

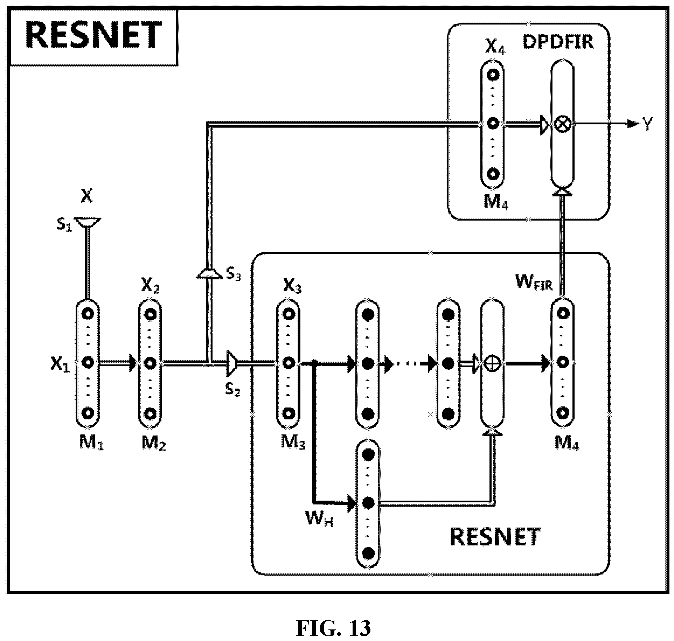

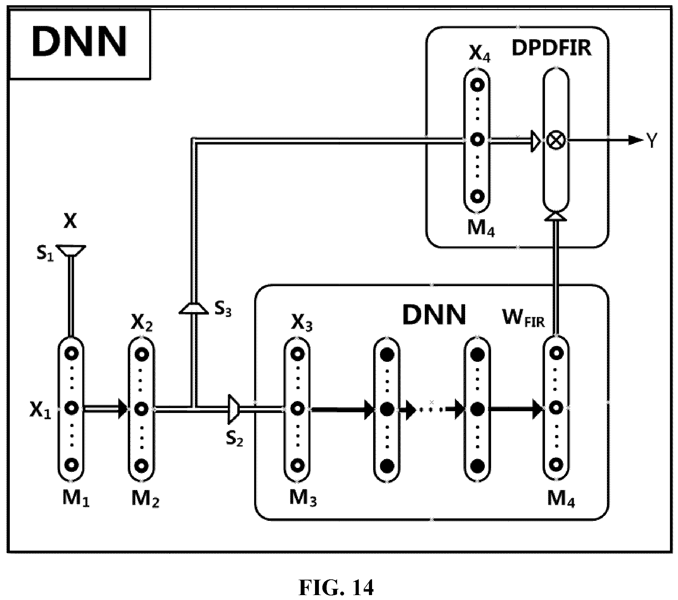

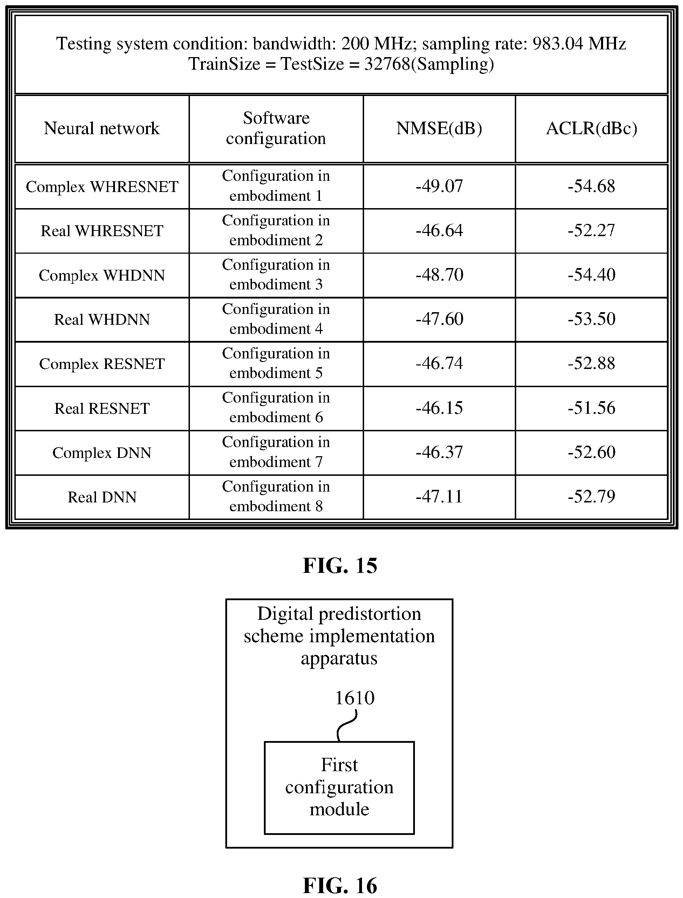

FIG. 11 is a diagram of a neural network structure equivalent to a unified digital predistortion hardware structure that has undergone software configuration according to an embodiment of the present application. FIG. 12 is a diagram of a neural network structure equivalent to a unified digital predistortion hardware structure that has undergone software configuration according to an embodiment of the present application. FIG. 13 is a diagram of a neural network structure equivalent to a unified digital predistortion hardware structure that has undergone software configuration according to an embodiment of the present application. FIG. 14 is a diagram of a neural network structure equivalent to a unified digital predistortion hardware structure that has undergone software configuration according to an embodiment of the present application. FIG. 15 is a diagram illustrating test performance comparison between eight neural networks obtained by software configuration on a unified digital predistortion hardware structure according to an embodiment of the present application.

In an embodiment, an intermediate-frequency digital predistortion (AI-DPD) method by using neural-networks is provided. The method includes the following:

The unified digital predistortion hardware structure shown in FIG. 5 is used, and the configuration of [complex WHRESNET] in the first row of the software configuration table shown in FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix (that is, the fully connected weight matrix in the previous embodiment) between the input layer and the first hidden layer of the W-H module and the coefficient matrix (that is, the fully connected weight matrix in the previous embodiment) between the first hidden layer and the second hidden layer of the W-H module are denoted as **W**_{*L*₁} and **W**_{*L*₂} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of a hot link in the RESNET module is denoted as **W***_{H}*. The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:

In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag *Ψ*(Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 7. *K̅_{I̅_{A}}*, *̅K̅*̅_{*̅I̅*̅_{B}}, *̅K̅*̅_{Q̅_{A}}, and *̅K̅*̅_{Q̅_{B}} are weighted vectors of the real part component vectors (*I̅_{A}* and *I̅_{B}*) of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 9. *J̅_{I̅_{U}}*, *J̅_{I̅_{V}}, J̅_{Q̅_{U}},* and *J̅_{Q̅_{V}}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 8. *C̅_{I̅_{G}}*, *C̅_{I_{W}}*, *C̅_{Q̅_{G}}*, and *C̅_{Q̅_{W}}* are weighted vectors of the real part component vectors (*I̅_{G}* and *I̅_{W}* ) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

The software configuration of [complex WHRESNET] includes, but is not limited to the following:
[W-H module]: The fully connected weight matrices *W*_{*L*₁} and *W*_{*L*₂} of the single hidden layer and the output layer cannot be configured as an all-zero matrix (denoted as 0) and an identity matrix (denoted as I), but can be configured to, including, but not be limited to random initialization, historical training weight initialization, or other constant weight initialization.
[RESNET module]: The fully connected weight matrix *W_{H}* of the hot link cannot be configured as an all-zero matrix and an identity matrix, but can be configured to, including, but not be limited to random initialization, historical training weight initialization, or other constant weight initialization.
[Full connection]: *C̅_{I̅_{G}}*, *C̅_{I̅_{W}}*, *C̅_{Q̅_{G}}*, and *C̅_{Q̅_{W}}* are all configured as an all-one matrix (denoted as 1).
[Complex inner product]: *J̅_{I̅_{U}}*, *J̅_{I̅_{V}}* , *J̅_{Q̅_{U}}* , and *J̅_{Q̅_{V}}* are all configured as an all-one matrix.
[Complex pointwise addition]: *K̅_{I̅_{A}}, K̅*_{*̅I̅*̅_{B}}, *̅K̅*̅_{Q̅_{A}} and *̅K̅*̅_{Q̅_{B}} are all configured as an all-one matrix.

When the software configuration of [complex WHRESNET] is used, the unified hardware structure of FIG. 5 is equivalent to the structure of FIG. 11. The obtained good performance (NMSE: normalized mean square error and ACLR: adjacent channel leakage ratio) is as shown in the first row of the table of FIG. 15.

In an embodiment, an intermediate-frequency digital predistortion (AI-DPD) method by using neural-networks is provided. The method includes the following:

The unified digital predistortion hardware structure of FIG. 5 is used, and the configuration of [real WHRESNET] in the second row of the software configuration table of FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix between the input layer and the first hidden layer of the W-H module and the coefficient matrix between the first hidden layer and the second hidden layer of the W-H module are denoted as **W**_{*L*₁} and **W**_{*L*₂} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of a hot link in the RESNET module is denoted as **W***_{H}* . The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:

In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag Ψ (Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 7. *K̅_{I̅_{A}} , K̅*_{*̅I̅*̅_{B}}*,* *̅K̅*̅_{Q̅_{A}}, and *̅K̅*̅_{Q̅_{B}} are weighted vectors of the real part component vectors (*I̅_{A}* and *I̅_{B}*) of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 9. *J̅_{I̅_{U}}*, *J̅_{I̅_{V}}*, *J̅_{Q̅_{U}}* , and *J̅_{Q̅_{V}}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 8. *C̅_{I̅_{G}} , C̅_{I̅_{W}} , C̅_{Q̅_{G}},* and *C̅_{Q̅_{W}}* are weighted vectors of the real part component vectors (*I̅_{_{G}}* and *I̅_{W}*) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

The software configuration of [real WHRESNET] includes, but is not limited to the following:
[W-H module]: The fully connected weight matrices *W*_{*L*₁} and *W*_{*L*₂} of the single hidden layer and the output layer cannot be configured as an all-zero matrix and an identity matrix, but can be configured to, including, but not be limited to random initialization, historical training weight initialization, or other constant weight initialization.
[RESNET module]: The fully connected weight matrix **W***_{H}* of the hot link cannot be configured as an all-zero matrix and an identity matrix, but can be configured to, including, but not be limited to random initialization, historical training weight initialization, or other constant weight initialization.
[Full connection]: *C̅_{I_{G}}* and *C̅_{I̅_{W}}* are configured as an all-one matrix. *C̅_{Q̅_{G}}* and *C̅_{Q̅_{W}}* are configured as an all-zero matrix.
[Complex inner product]: *J̅_{I̅_{U}}* and *J̅_{I̅_{V}}* are configured as an all-one matrix. *J̅_{Q̅_{U}}* and *J̅_{Q̅_{V}}* are configured as an all-zero matrix.
[Complex pointwise addition]: *K̅_{I̅_{A}}* and *̅K̅*̅_{*̅I̅*̅_{B}} are configured as an all-one matrix. *̅K̅*̅_{Q̅_{A}} and *̅K̅*̅_{Q̅_{B}} are configured as an all-zero matrix.

When the software configuration of [real WHRESNET] is used, the unified hardware structure of FIG. 5 is equivalent to the structure of FIG. 11. The obtained good performance (NMSE: normalized mean square error and ACLR: adjacent channel leakage ratio) is as shown in the second row of the table of FIG. 15.

In an embodiment, an intermediate-frequency digital predistortion (AI-DPD) method by using neural-networks is provided. The method includes the following:

The unified digital predistortion hardware structure shown in FIG. 5 is used, and the configuration of [complex WHDNN] in the third row of the software configuration table shown in FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix of the hidden layer of the W-H module and the coefficient matrix of the output layer of the W-H module are denoted as **W**_{*L*₁} and **W**_{*L*₂} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of the hot link in the RESNET module is denoted as **W***_{H}*. The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:

In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag Ψ (Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 7. *K̅_{I̅_{A}} , K̅*_{*̅I̅*̅_{B}}*,* *̅K̅*̅_{Q̅_{A}}, and *K*_{Q̅_{B}} are weighted vectors of the real part component vectors (*I̅_{A}* and *I̅_{B}*) of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 9. *J̅_{I̅_{U}}* , *J̅_{I̅_{V}}, J̅_{Q̅_{U}},* , and *J̅_{Q̅_{V}}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 8. *C̅_{I̅_{G}} , C̅_{I̅_{W}}*, *C̅_{Q̅_{G}}*, and *C̅_{Q̅_{W}}* are weighted vectors of the real part component vectors (*I̅_{G}* and *I̅_{W}*) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

The software configuration of [complex WHDNN] includes, but is not limited to the following:
[W-H module]: The fully connected weight matrices **W**_{*L*₁} and **W**_{*L*₂} of the single hidden layer and the output layer cannot be configured as an all-zero matrix (denoted as 0) and an identity matrix (denoted as I), but can be configured to, including, but not be limited to random initialization, historical training weight initialization, or other constant weight initialization.
[RESNET module]: The fully connected weight matrix **W***_{H}* of the hot link is configured as an all-zero matrix.
[Full connection]: *C̅_{I̅_{G}}* , *C̅_{I̅_{W}}* , *C̅_{Q̅_{G}},* and *C̅_{Q̅_{W}}* are all configured as an all-one matrix (denoted as 1).
[Complex inner product]: *J̅_{I̅_{U}} , J̅_{I̅_{V}} J̅_{Q̅_{U}}*, and *J̅_{Q̅_{V}}* are all configured as an all-one matrix.
[Complex pointwise addition]: *K̅_{I̅_{A}} , K̅*_{*̅I̅*̅_{B}}*,* *̅K̅*̅_{Q̅_{A}}, and *̅K̅*̅_{Q̅_{B}} are all configured as an all-one matrix.

When the software configuration of [complex WHDNN] is used, the unified hardware structure of FIG. 5 is equivalent to the structure of FIG. 12. The obtained good performance (NMSE: normalized mean square error and ACLR: adjacent channel leakage ratio) is as shown in the third row of the table of FIG. 15.

In an embodiment, an intermediate-frequency digital predistortion (AI-DPD) method by using neural-networks is provided. The method includes the following:
The unified digital predistortion hardware structure shown in FIG. 5 is used, and the configuration of [real WHDNN] in the fourth row of the software configuration table shown in FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix between the input layer and the first hidden layer of the W-H module and the coefficient matrix between the first hidden layer and the second hidden layer of the W-H module are denoted as **W**_{*L*₁} and **W**_{*L*₂} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of the hot link in the RESNET module is denoted as **W***_{H}*. The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:
In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag *ψ*(Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 7. *K̅_{I̅_{A}}* , *̅K̅*̅_{*̅I̅*̅_{B}}*,* *̅K̅*̅_{Q̅_{A}}, and *̅K̅*̅_{Q̅_{B}} are weighted vectors of the real part component vectors (*I̅_{A}* and *I̅_{B}*) of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 9. *J̅_{I̅_{U}}*, *J̅_{I̅_{V}}, J̅_{Q̅_{U}}*, and *J_{Q̅_{V}}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 8. *C̅_{I̅_{G}}, _{I̅_{W}}*,*C̅_{Q̅_{G}},* and *C̅_{Q̅W}* are weighted vectors of the real part component vectors (*I̅_{G}* and *I̅_{W}* ) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

The software configuration of [real WHDNN] includes, but is not limited to the following:
[W-H module]: The fully connected weight matrices **W**_{*L*₁} and **W**_{*L*₂} of the single hidden layer and the output layer cannot be configured as an all-zero matrix and an identity matrix, but can be configured to, including, but not be limited to random initialization, historical training weight initialization, or other constant weight initialization.
[RESNET module]: The fully connected weight matrix **W***_{H}* of the hot link is configured as an all-zero matrix.
[Full connection]: *C̅_{I̅_{G}}* and *C̅_{I̅_{W}}* are configured as an all-one matrix. *C̅_{Q̅_{G}}* and *C̅_{Q̅_{W}}* are configured as an all-zero matrix.
[Complex inner product]: *J̅_{I̅_{U}}* and *J̅_{I̅_{V}}* are configured as an all-one matrix. *J̅_{Q̅_{U}}* and *J̅_{Q̅_{V}}* are configured as an all-zero matrix.
[Complex pointwise addition]: *K̅_{I̅_{A}}* and *̅K̅*̅_{*̅I̅*̅_{B}} are configured as an all-one matrix. *̅K̅*̅_{Q̅_{A}} and *̅K̅*̅_{Q̅_{B}} are configured as an all-zero matrix.

When the software configuration of [real WHDNN] is used, the unified hardware structure of FIG. 5 is equivalent to the structure of FIG. 12. The obtained good performance (NMSE: normalized mean square error and ACLR: adjacent channel leakage ratio) is as shown in the fourth row of the table of FIG. 15.

In an embodiment, an intermediate-frequency digital predistortion (AI-DPD) method by using neural-networks is provided. The method includes the following:
The unified digital predistortion hardware structure shown in FIG. 5 is used, and the configuration of [complex RESNET] in the fifth row of the software configuration table shown in FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix between the input layer and the first hidden layer of the W-H module and the coefficient matrix between the first hidden layer and the second hidden layer of the W-H module are denoted as **W**_{*L*1} and **W**_{*L*2} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of the hot link in the RESNET module is denoted as **W***_{H}*. The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:
In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag Ψ (Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 7. *K̅_{I̅_{A}}, K̅*_{*̅I̅*̅_{B}}*,* *̅K̅*̅_{Q̅_{A}} , and *̅K̅*̅_{Q̅_{B}} are weighted vectors of the real part component vectors (*I̅_{A}* and *I̅_{B}*) of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 9. *J̅_{I̅_{U}}* , *J̅_{I̅_{V}}, J̅_{Q̅_{U}}* , and *J̅_{Q̅_{V}}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 6. *C̅_{I̅_{G}}, C̅_{I̅_{W}}*, *C̅_{Q̅G},* and *C̅_{Q̅_{W}}* are weighted vectors of the real part component vectors (*I̅_{G}* and *I̅_{W}*) of the input vector G of the connection edge and the edge weight vector W and weighted vectors of the imaginary part component vectors (*Q̅_{_{G}}* and *Q̅_{_{W}}*) of the input vector G of the connection edge and the edge weight vector W respectively. Here the value range of each vector element is {0, 1}.

The software configuration of [complex RESNET] includes, but is not limited to the following:
[W-H module]: The fully connected weight matrices *W*_{*L*₁} and *W*_{*L*₂} of the single hidden layer and the output layer are configured as an identity matrix.
[RESNET module]: The fully connected weight matrix **W***_{H}* of the hot link cannot be configured as an all-zero matrix and an identity matrix, but can be configured to, including, but not be limited to random initialization, historical training weight initialization, or other constant weight initialization.
[Full connection]: *C̅_{I̅_{G}}* , *C̅_{I̅_{W}}* , *C̅_{Q̅_{G}},* and *C̅_{Q̅_{W}}* are all configured as an all-one matrix (denoted as 1).
[Complex inner product]: *J̅_{I̅_{U}} , J̅_{I̅_{V}}, J̅_{Q̅_{U}}* , and *J̅_{Q̅_{V}}* are all configured as an all-one matrix.
[Complex pointwise addition]: *K̅_{I̅_{A}}*, *̅K̅*̅_{*̅I̅*̅_{B}}, *K̅_{Q̅_{A}}*, and *̅K̅*̅_{Q̅_{B}} are all configured as an all-one matrix.

When the software configuration of [complex RESNET] is used, the unified hardware structure of FIG. 5 is equivalent to the structure of FIG. 13. The obtained good performance (NMSE: normalized mean square error and ACLR: adjacent channel leakage ratio) is as shown in the fifth row of the table of FIG. 15.

In an embodiment, an intermediate-frequency digital predistortion (AI-DPD) method by using neural-networks is provided. The method includes the following:
The unified digital predistortion hardware structure shown in FIG. 5 is used, and the configuration of [real RESNET] in the sixth row of the software configuration table shown in FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix between the input layer and the first hidden layer of the W-H module and the coefficient matrix between the first hidden layer and the second hidden layer of the W-H module are denoted as **W**_{*L*₁} and **W**_{*L*₂} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of the hot link in the RESNET module is denoted as **W***_{H}*. The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:

In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag Ψ (Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 7. *K̅_{I̅_{A}} , K̅*_{*̅I̅*̅_{B}}*,* *̅K̅*̅_{Q̅_{A}}, and *̅K̅*̅_{Q̅_{B}} are weighted vectors of the real part component vectors (*I̅_{A}* and *I̅_{B}*) of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 9. *J̅_{I̅_{U}}* , *J̅_{I̅_{V}}, J̅_{Q̅_{U}}* , and *J̅_{Q̅V}.* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 8. *C̅_{I_{G}} , C̅_{I̅_{W}} , C̅_{Q̅_{G}},* and *C̅_{Q̅_{W}}* are weighted vectors of the real part component vectors (*I̅_{G}* and *I̅_{W}*) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

The software configuration of [real RESNET] includes, but is not limited to the following:
[W-H module]: The fully connected weight matrices **W**_{*L*₁} and **W**_{*L*₂} of the single hidden layer and the output layer are configured as an identity matrix.
[RESNET module]: The fully connected weight matrix **W***_{H}* of the hot link cannot be configured as an all-zero matrix and an identity matrix, but can be configured to, including, but not be limited to random initialization, historical training weight initialization, or other constant weight initialization.
[Full connection]: *C̅_{I̅_{G}}* and *C̅_{I̅_{W}}* are configured as an all-one matrix. *C̅_{Q̅_{G}}* and *C̅_{Q̅_{W}}* are configured as an all-zero matrix.
[Complex inner product]: *J̅_{I̅_{U}}* and *J̅_{I̅_{V}}* are configured as an all-one matrix. *J̅_{Q̅_{V}}* and *J̅_{Q̅_{V}}* are configured as an all-zero matrix.
[Complex pointwise addition]: *K̅_{I̅^{A}}* and *̅K̅I̅*̅_{_{B}} are configured as an all-one matrix. *̅K̅*̅_{Q̅_{A}} and *̅K̅*̅_{Q̅_{B}} are configured as an all-zero matrix.

When the software configuration of [real RESNET] is used, the unified hardware structure of FIG. 5 is equivalent to the structure of FIG. 13. The obtained good performance (NMSE: normalized mean square error and ACLR: adjacent channel leakage ratio) is as shown in the sixth row of the table of FIG. 15.

In an embodiment, an intermediate-frequency digital predistortion (AI-DPD) method by using neural-networks is provided. The method includes the following:
The unified digital predistortion hardware structure shown in FIG. 5 is used, and the configuration of [complex DNN] in the seventh row of the software configuration table shown in FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix between the input layer and the first hidden layer of the W-H module and the coefficient matrix between the first hidden layer and the second hidden layer of the W-H module are denoted as **W**_{*L*₁} and **W**_{*L*₂} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of the hot link in the RESNET module is denoted as **W***_{H}* . The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:
In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag Ψ (Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 7. *K̅_{I̅_{A}} , K̅*_{*̅I̅*̅_{B}}*,* *̅K̅*̅_{Q̅_{A}}, and *̅K̅*̅_{Q̅_{B}} are weighted vectors of the real part component vectors (*I̅_{A}* and *I̅_{B}*) of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 9. *J̅_{I̅_{U}}* , *J̅_{I̅_{V}}, J̅_{Q̅_{U}}*, and *J̅_{Q̅_{V}}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 8. *C̅_{I_{G}}* , *C̅_{I̅_{W}}* , *C̅_{Q̅G},* and *C̅_{Q̅_{W}}* are weighted vectors of the real part component vectors (*I̅_{G}* and *I̅_{W}*) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

The software configuration of [complex DNN] includes, but is not limited to the following:

[W-H module]: The fully connected weight matrices **W**_{*L*₁} and **W**_{*L*₂} of the single hidden layer and the output layer are configured as an identity matrix.
[RESNET module]: The fully connected weight matrix **W***_{H}* of the hot link is configured as an all-zero matrix.
[Full connection]: *C̅_{I̅_{G}}, C̅_{I̅_{W}} , C̅_{Q̅_{G}},* and *C̅_{Q̅W}* are all configured as an all-one matrix (denoted as 1).
[Complex inner product]: *J̅_{I̅_{U}}* , *J̅_{I̅_{V}}, J̅_{Q̅_{U}}*, and *J̅_{Q̅_{V}}* are all configured as an all-one matrix.
[Complex pointwise addition]: *K̅_{I̅_{A}}*, *̅K̅*̅_{*̅I̅*̅_{B}}, *̅K̅*̅_{Q̅_{A}}, and *̅K̅*̅_{Q̅B} are all configured as an all-one matrix.

When the software configuration of [complex DNN] is used, the unified hardware structure of FIG. 5 is equivalent to the structure of FIG. 14. The obtained good performance (NMSE: normalized mean square error and ACLR: adjacent channel leakage ratio) is as shown in the seventh row of the table of FIG. 15.

In an embodiment, an intermediate-frequency digital predistortion (AI-DPD) method by using neural-networks is provided. The method includes the following:
The unified digital predistortion hardware structure shown in FIG. 5 is used, and the configuration of [real DNN] in the eighth row of the software configuration table shown in FIG. 10 is used.

The unified digital predistortion hardware structure is composed of three modules: a W-H module, a RESNET module, and a DPDFIR module.

The W-H module stands for Wiener-Hammerstein filter module. The W-H module can be equivalent to a fully connected network having two hidden layers. Processing in the hidden layer and output layer of the W-H module involves only linear weighting and summing without any nonlinear activation. The coefficient matrix between the input layer and the first hidden layer of the W-H module and the coefficient matrix between the first hidden layer and the second hidden layer of the W-H module are denoted as **W**_{*L*₁} and **W**_{*L*₂} respectively. The input to this module is a signal vector X1, with a length of M1. The output of this module is a signal vector X2, with a length of M2.

The RESNET module is a neural network whose hop link first undergoes a fully connected layer and then skips across multiple layers to undergo complex pointwise addition with a subsequent layer, not a traditional residual network structure. As shown in FIG. 5, a fully connected weight matrix of the hot link in the RESNET module is denoted as **W***_{H}* . The input to this module is a signal vector X3, with a length of M3. The output of this module is a filter coefficient vector WFIR, with a length of M4.

The DPDFIR module is a predistortion filter module. The filter coefficient of the DPDFIR module is output and provided by the RESNET module. Processing of the DPDFIR module involves [complex inner product] as shown in FIG. 9. As shown in FIG. 5, this module has two input vectors: a signal vector X4, with a length of M4; and a filter coefficient vector WFIR, with a length of Y.

Processing between modules and processing between units of each module are indicated by tags in FIG. 6.

The tag [preprocessing] in FIG. 6 includes, but is not limited to the following: taking a real part and an imaginary part of a complex vector to form a real part vector and an imaginary part vector respectively, taking a magnitude of a complex vector to form a magnitude vector, taking a conjugate of a complex vector to form a conjugate vector, or concatenating a complex vector and at least one of the previous vectors.

The preprocessed signal vector is X2, with a length of M2.

The tag [selection] in FIG. 6 includes, but is not limited to the following:
In FIG. 5, processing of the tag [S1] is to select partial or all output from the signal vector X (with a length of M) to form the signal vector X1 (with a length of M1). M1 < M. The partial output includes, but is not limited to, streaming processing. For example, at the first time step, X1(1) = [X(1), ..., X(6)]; at the second time step, X1(2) = [X(2), ..., X(7)]; at the third time step, X1(3) = [X(3), ..., X(8)]; and so on.

In FIG. 5, processing of the tag [S2] is to select partial or all output from the signal vector X2 (with a length of M2) to form the signal vector X3 (with a length of M3). M3 ≤ M2. The partial output includes, but is not limited to, (a) output of a magnitude vector from X2 or (b) output of the concatenated vector of the complex vector and the magnitude vector from X2.

In FIG. 5, processing of the tag [S3] is to select partial output from the signal vector X2 (with a length of M2) to form the signal vector X4 (with a length of M4). M4 < M2. The partial output includes, but is not limited to, (a) the complex vector or (b) the concatenated vector of the complex vector and the magnitude vector from.

The tag Σ(•) in FIG. 6: indicates weighting and summing of all inputs of the neuron. Here the summing includes addition of bias of the neuron.

The tag Ψ (Σ(•)) in FIG. 6: indicates weighting and summing of all inputs of the neuron and making the summed result passing through the activation function of the neuron.

The tag [complex pointwise addition] in FIG. 6: indicates elementwise addition between equal-length complex vectors. For its structure, see FIG. 4. *K̅_{I̅A} , K̅*_{*̅I̅*̅B}*,* *̅K̅*̅_{Q̅A}, and *̅K̅*̅_{Q̅B} are weighted vectors of the real part component vectors (*I̅_{A}* and *̅I̅_̅{̅B̅}̅*̅)̅ of the two complex operation vectors A and B of the complex pointwise addition and weighted vectors of the imaginary part component vectors (*Q̅_{A}* and *Q̅_{B}*) of the two complex operation vectors A and B of the complex pointwise addition respectively. Here the value range of each vector element is {0, 1}.

The tag [complex inner product] in FIG. 6: indicates the mathematical description of predistortion filtering. For its structure, see FIG. 5. *J̅_{I̅_{U}}* , *J̅_{I_{V}}, J̅_{Q̅_{U}}*, and *J̅_{Q̅_{V}}* are weighted vectors of the real part component vectors (*I̅_{U}* and *I̅_{V}*) of the two complex operation vectors U and V of the complex inner product and weighted vectors of the imaginary part component vectors (*Q̅_{U}* and *Q̅_{V}*) of the two complex operation vectors U and V of the complex inner product respectively. Here the value range of each vector element is {0, 1}.

The tag [full connection] in FIG. 6: indicates complex full connection processing between neurons in the previous layer and neurons in the subsequent layer. For its structure, see FIG. 6. *C̅_{I̅_{G}}, C̅_{I̅_{W}}, C̅_{Q̅_{G}},* and *C̅_{Q̅_{W}}* are weighted vectors of the real part component vectors (*I̅_{G}* and *I̅_{W}*) of the input vector G of the connection edge and the edge weight vector W and weighted vectors of the imaginary part component vectors (*Q̅_{G}* and *Q̅_{W}*) of the input vector G of the connection edge and the edge weight vector W respectively. Here the value range of each vector element is {0, 1}.

The software configuration of [real DNN] includes, but is not limited to the following:
[W-H module]: The fully connected weight matrices **W**_{*L*₁} and **W**_{*L*₂} of the single hidden layer and the output layer are configured as an identity matrix.
[RESNET module]: The fully connected weight matrix **W***_{H}* of the hot link is configured as an all-zero matrix.
[Full connection]: *C̅_{I̅G}* and *C̅_{I̅_{W}}* are configured as an all-one matrix. *C̅_{Q̅_{G}}* and *C̅_{Q̅_{W}}* are configured as an all-zero matrix.
[Complex inner product]: *J̅_{I̅_{U}}* and *J̅_{I̅_{V}}* are configured as an all-one matrix. *J̅_{Q̅_{U}}* and *J̅_{Q̅_{V}}* are configured as an all-zero matrix.
[Complex pointwise addition]: *K̅_{I̅_{A}}* and *̅K̅*̅_{*̅I̅*̅_{B}} are configured as an all-one matrix. *K̅_{Q̅_{A}}* and *̅K̅*̅_{Q̅_{B}} are configured as an all-zero matrix.

When the software configuration of [real DNN] is used, the unified hardware structure of FIG. 5 is equivalent to the structure of FIG. 14. The obtained good performance (NMSE: normalized mean square error and ACLR: adjacent channel leakage ratio) is as shown in the eighth row of the table of FIG. 15.

FIG. 16 is a block diagram of a digital predistortion scheme implementation apparatus according to an embodiment of the present application. This embodiment is applied to a digital predistortion scheme implementation device. As shown in FIG. 16, the digital predistortion scheme implementation apparatus of this embodiment includes a first configuration module 1610.

The first configuration module 1610 is configured to obtain artificial-intelligence-digital-predistortion schemes of eight neural-networks by using a unified digital predistortion (DPD) hardware structure and using software configuration.

In an embodiment, the unified digital predistortion hardware structure includes a WH module, a residual network module, and a digital predistortion filter module.

The output of the WH module is connected to the input of the residual network module and the input of the digital predistortion filter module. The output of the residual network module is connected to the input of the digital predistortion filter module.

In an embodiment, the WH module is equivalent to a fully connected network having two hidden layers, the hot link in the residual network module first undergoes a fully connected layer and then skips across multiple layers to undergo complex pointwise addition with a subsequent layer, and the filter coefficient of the digital predistortion filter module is provided by the residual network module.

In an embodiment, the WH module includes an input layer, a first hidden layer, a second hidden layer, and an output layer. The input layer is fully connected to the first hidden layer. The first hidden layer is fully connected to the second hidden layer. Preprocessing is performed between the second hidden layer and the output layer.

The WH module is configured to filter and preprocess an input signal vector and feed the preprocessed signal vector into the residual network module and the digital predistortion filter module separately.

In an embodiment, the preprocessing includes at least one of the following: taking a real part and an imaginary part of a complex vector to form a real part vector and an imaginary part vector respectively, taking a magnitude of a complex vector to form a magnitude vector, taking a conjugate of a complex vector to form a conjugate vector, concatenating a complex vector and a magnitude vector to form a concatenated vector, or concatenating a complex vector and a conjugate vector to form a concatenated vector.

In an embodiment, the residual network module includes an input layer, at least two hidden layers, and an output layer.

The at least two hidden layers are fully connected to each other and undergo complex pointwise addition to obtain a filter coefficient vector.

In an embodiment, the residual network module also includes a hidden layer of the hot link.

The hidden layer of the hot link undergoes full connection and undergoes complex pointwise addition with the last hidden layer of at least two hidden layers to obtain a filter coefficient vector.

In an embodiment, the complex pointwise addition includes at least real part component vectors and imaginary part component vectors of two complex operation vectors.

Weighted vectors of the real part component vectors of the two complex operation vectors include an all-one matrix.

Weighted vectors of the imaginary part component vectors of the two complex operation vectors include one of an all-one matrix or an all-zero matrix.

In an embodiment, the full connection includes at least a real part component and an imaginary part component vector of an input vector of a connection edge and a real part component and an imaginary part component vector of an edge weight vector.

The weighted vector of the real part component includes an all-one matrix. The weighted vector of the imaginary part component vector includes one of an all-one matrix or an all-zero matrix.

In an embodiment, the filter coefficient of the digital predistortion filter module is provided by the residual network module, and the digital predistortion filter module includes two input vectors: a signal vector and a filter coefficient vector.

In an embodiment, the complex inner product of the digital predistortion filter module includes at least real part component vectors and imaginary part component vectors of two complex operation vectors.

Weighted vectors of the real part component vectors of the two complex operation vectors include an all-one matrix.

Weighted vectors of the imaginary part component vectors of the two complex operation vectors include one of an all-one matrix or an all-zero matrix.

The digital predistortion scheme implementation apparatus is configured to implement the method for implementing a digital predistortion scheme of the embodiment shown in FIG. 2 and has similar implementation principles and technical effects. The implementation principles and technical effects are not repeated here.

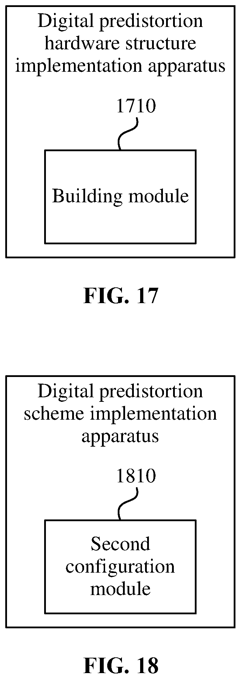

FIG. 17 is a block diagram of a digital predistortion hardware structure implementation apparatus according to an embodiment of the present application. This embodiment is applied to a digital predistortion hardware structure implementation device. As shown in FIG. 17, the digital predistortion hardware structure implementation apparatus of this embodiment includes a building module 1710.

The building module 1710 is configured to prebuild a unified digital predistortion hardware structure. The unified digital predistortion hardware structure is configured to implement artificial-intelligence-digital-predistortion.

In an embodiment, the unified digital predistortion hardware structure includes a WH module, a residual network module, and a digital predistortion filter module.

The output of the WH module is connected to the input of the residual network module and the input of the digital predistortion filter module. The output of the residual network module is connected to the input of the digital predistortion filter module.

In an embodiment, the WH module is equivalent to a fully connected network having two hidden layers, the hot link in the residual network module first undergoes a fully connected layer and then skips across multiple layers to undergo complex pointwise addition with a subsequent layer, and the filter coefficient of the digital predistortion filter module is provided by the residual network module.

In an embodiment, the WH module includes an input layer, a first hidden layer, a second hidden layer, and an output layer. The input layer is fully connected to the first hidden layer. The first hidden layer is fully connected to the second hidden layer. Preprocessing is performed between the second hidden layer and the output layer.

The WH module is configured to filter and preprocess an input signal vector and feed the preprocessed signal vector into the residual network module and the digital predistortion filter module separately.

In an embodiment, the preprocessing includes at least one of the following: taking a real part and an imaginary part of a complex vector to form a real part vector and an imaginary part vector respectively, taking a magnitude of a complex vector to form a magnitude vector, taking a conjugate of a complex vector to form a conjugate vector, concatenating a complex vector and a magnitude vector to form a concatenated vector, or concatenating a complex vector and a conjugate vector to form a concatenated vector.

In an embodiment, the residual network module includes an input layer, at least two hidden layers, and an output layer.

The at least two hidden layers are fully connected to each other and undergo complex pointwise addition to obtain a filter coefficient vector.

In an embodiment, the residual network module also includes a hidden layer of the hot link.

The hidden layer of the hot link undergoes full connection and undergoes complex pointwise addition with the last hidden layer of at least two hidden layers to obtain a filter coefficient vector.

In an embodiment, the complex pointwise addition includes at least real part component vectors and imaginary part component vectors of two complex operation vectors.

Weighted vectors of the real part component vectors of the two complex operation vectors include an all-one matrix.

Weighted vectors of the imaginary part component vectors of the two complex operation vectors include one of an all-one matrix or an all-zero matrix.

In an embodiment, the full connection includes at least a real part component and an imaginary part component vector of an input vector of a connection edge and a real part component and an imaginary part component vector of an edge weight vector.

The weighted vector of the real part component includes an all-one matrix. The weighted vector of the imaginary part component vector includes one of an all-one matrix or an all-zero matrix.

In an embodiment, the digital predistortion filter module includes an input layer and a complex inner product layer.

A signal vector input to the input layer and a filter coefficient vector provided by the residual network module are processed in the complex inner product layer to obtain a digitally predistorted filtered signal scalar.

In an embodiment, the complex inner product of the digital predistortion filter module includes at least real part component vectors and imaginary part component vectors of two complex operation vectors.

Weighted vectors of the real part component vectors of the two complex operation vectors include an all-one matrix.

Weighted vectors of the imaginary part component vectors of the two complex operation vectors include one of an all-one matrix or an all-zero matrix.

The digital predistortion hardware structure implementation apparatus is configured to implement the digital predistortion hardware structure implementation method of the embodiment shown in FIG. 3 and has similar implementation principles and technical effects. The implementation principles and technical effects are not repeated here.

FIG. 18 is a block diagram of a digital predistortion scheme implementation apparatus according to an embodiment of the present application. This embodiment is applied to a digital predistortion scheme implementation device. As shown in FIG. 18, the digital predistortion scheme implementation apparatus of this embodiment includes a second configuration module 1810.

The second configuration module 1810 is configured to obtain artificial-intelligence-digital-predistortion schemes of eight neural-networks by using software configuration.

In an embodiment, obtaining the AI-DPD schemes of eight neural-networks by using the software configuration includes obtaining the AI-DPD schemes of eight neural-networks by reconfiguring a fully connected weight matrix between an input layer of a WH module and a first hidden layer of the WH module and a fully connected weight matrix between the first hidden layer of the WH module and a second hidden layer of the WH module and reconfiguring a fully connected weight matrix of the hot link in a residual network module by using the software configuration.

In an embodiment, the fully connected weight matrix between the input layer and the first hidden layer and the fully connected weight matrix between the first hidden layer and the second hidden layer are configured in one of the following manners: identity matrix, random initialization, historical training weight initialization, or other constant weight initialization.

In an embodiment, the fully connected weight matrix of the hot link in the residual network module are configured in one of the following manners: all-zero matrix, random initialization, historical training weight initialization, or other constant weight initialization.

The digital predistortion scheme implementation apparatus is configured to implement the method for implementing a digital predistortion scheme of the embodiment shown in FIG. 4 and has similar implementation principles and technical effects. The implementation principles and technical effects are not repeated here.

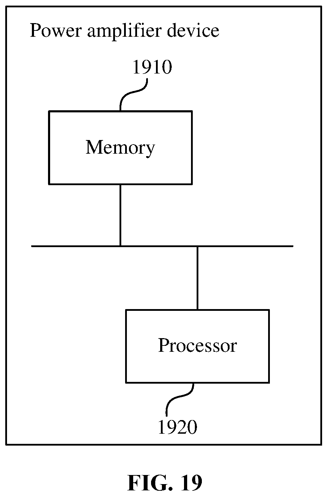

FIG. 19 is a diagram illustrating the structure of a power amplifier device according to an embodiment of the present application. As shown in FIG. 19, the device of the present application includes a processor 1910 and a memory 1920. One or more processors 1910 may be configured in the device. FIG. 19 uses one processor 1910 as an example. One or more memories 1920 may be configured in the device. FIG. 19 uses one memory 1920 as an example. The processor 1910 and memory 1920 of the device are connected by a bus or in other manners. The connection by a bus is used as an example in FIG. 19.

The memory 1920, as a computer-readable storage medium, may be configured to store software programs and computer-executable programs and modules such as program instructions/modules corresponding to the device of any embodiment of the present application (such as the first configuration module 1610 in the digital predistortion scheme implementation apparatus). The memory 1920 may include a program storage region and a data storage region. The program storage region may store an operating system and an application program required by at least one function. The data storage region may store data created according to the use of the device. Additionally, the memory 1920 may include a high-speed random-access memory or a nonvolatile memory such as at least one disk memory, a flash memory or another nonvolatile solid-state memory. In some examples, memories 1920 remote from the processor 1910 and connectable to the device via a network may be provided. Examples of the preceding network include, but are not limited to, the Internet, an intranet, a local area network, a mobile communication network, and a combination thereof.

In the case where the power amplifier device is a digital predistortion scheme implementation device, the power amplifier device may be configured to perform the method for implementing a digital predistortion scheme of any previous embodiment and has corresponding functions and effects.

In the case where the power amplifier device is a digital predistortion hardware structure implementation device, the power amplifier device may be configured to perform the digital predistortion hardware structure implementation method of any previous embodiment and has corresponding functions and effects.

An embodiment of the present application provides a storage medium including computer-executable instructions. When executed by a computer processor, the computer-executable instructions cause the processor to perform a method for implementing a digital predistortion scheme. The method includes obtaining artificial-intelligence-digital-predistortion schemes of eight neural-networks by using a unified digital predistortion hardware structure and using software configuration.

An embodiment of the present application provides a storage medium including computer-executable instructions. When executed by a computer processor, the computer-executable instructions cause the processor to perform a digital predistortion hardware structure implementation method. The method includes prebuilding a unified digital predistortion hardware structure. The unified digital predistortion hardware structure is configured to implement artificial-intelligence-digital-predistortion.

An embodiment of the present application provides a storage medium including computer-executable instructions. When executed by a computer processor, the computer-executable instructions cause the processor to perform a method for implementing a digital predistortion scheme. The method includes obtaining artificial-intelligence-digital-predistortion schemes of eight neural-networks by using software configuration.

It is to be understood by those skilled in the art that the term "user equipment" encompasses any suitable type of wireless user equipment, for example, a mobile phone, a portable data processing apparatus, a portable web browser, or a vehicle-mounted mobile station.

Generally speaking, embodiments of the present application may be implemented in hardware or special-purpose circuits, software, logic, or any combination thereof. For example, some aspects may be implemented in hardware while other aspects may be implemented in firmware or software executable by a controller, a microprocessor, or another computing apparatus, though the present application is not limited thereto.

Embodiments of the present application may be implemented through the execution of computer program instructions by a data processor of a mobile apparatus, for example, implemented in a processor entity, by hardware, or by a combination of software and hardware. The computer program instructions may be assembly instructions, instruction set architecture (ISA) instructions, machine instructions, machine-related instructions, microcodes, firmware instructions, status setting data, or source or object codes written in any combination of one or more programming languages.

A block diagram of any logic flow among the drawings of the present application may represent program steps, may represent interconnected logic circuits, modules, and functions, or may represent a combination of program steps and logic circuits, modules, and functions. Computer programs may be stored in a memory. The memory may be of any type suitable for a local technical environment and may be implemented using any suitable data storage technology, such as, but not limited to, a read-only memory (ROM), a random-access memory (RAM), or an optical memory device and system (for example, a digital video disc (DVD) or a compact disc (CD)). Computer-readable media may include non-transitory storage media. The data processor may be of any type suitable for the local technical environment, such as, but not limited to, a general-purpose computer, a special-purpose computer, a microprocessor, a digital signal processor (DSP), an application-specific integrated circuit (ASIC), a field-programmable gate array (FPGA), and a processor based on a multi-core processor architecture.

## Claims

1. A method for implementing a digital predistortion scheme, comprising:
using a unified digital predistortion hardware structure, and obtaining artificial-intelligence-digital-predistortion schemes of eight neural-networks by using software configuration.

2. A method for implementing a digital predistortion hardware structure, comprising:
prebuilding the unified digital predistortion hardware structure, wherein the unified digital predistortion hardware structure is configured to implement artificial-intelligence-digital-predistortion.

3. A method for implementing a digital predistortion scheme, comprising:
obtaining artificial-intelligence-digital-predistortion schemes of eight neural-networks by using software configuration.

4. The method of claim 1 or 2, wherein the unified digital predistortion hardware structure comprises a Wiener-Hammerstein, WH, module, a residual network module, and a digital predistortion filter module,
wherein an output of the WH module is connected to an input of the residual network module and an input of the digital predistortion filter module respectively, and an output of the residual network module is connected to the input of the digital predistortion filter module.

5. The method of claim 4, wherein the WH module is equivalent to a fully connected network having two hidden layers, a hot link in the residual network module first undergoes a full connection and then skips across multiple layers to undergo complex pointwise addition with a subsequent layer, and a filter coefficient of the digital predistortion filter module is provided by the residual network module.

6. The method of claim 4, wherein the WH module comprises an input layer, a first hidden layer, a second hidden layer, and an output layer, wherein
the input layer is fully connected to the first hidden layer, the first hidden layer is fully connected to the second hidden layer, and preprocessing is performed between the second hidden layer and the output layer; and
the WH module is configured to filter and preprocess an input signal vector and feed the preprocessed signal vector into the residual network module and the digital predistortion filter module separately.

7. The method of claim 6, wherein the preprocessing comprises one of the following: taking a real part and an imaginary part of a complex vector to form a real part vector and an imaginary part vector respectively, taking a magnitude of a complex vector to form a magnitude vector, taking a conjugate of a complex vector to form a conjugate vector, concatenating a complex vector and a magnitude vector to form a concatenated vector, or concatenating a complex vector and a conjugate vector to form a concatenated vector.

8. The method of claim 4, wherein the residual network module comprises an input layer, at least two hidden layers, and an output layer, wherein
the at least two hidden layers are fully connected to each other and undergo complex pointwise addition to obtain a filter coefficient vector.

9. The method of claim 5, wherein the residual network module further comprises a hidden layer of the hot link; and
the hidden layer of the hot link undergoes full connection and undergoes complex pointwise addition with a last hidden layer of at least two hidden layers to obtain a filter coefficient vector.

10. The method of claim 8 or 9, wherein the complex pointwise addition comprises real part component vectors and imaginary part component vectors of two complex operation vectors, wherein
weighted vectors of the real part component vectors of the two complex operation vectors comprise an all-one matrix; and
weighted vectors of the imaginary part component vectors of the two complex operation vectors comprise one of an all-one matrix or an all-zero matrix.

11. The method of claim 8 or 9, wherein the full connection comprises a real part component vector and an imaginary part component vector of an input vector of a connection edge and a real part component vector and an imaginary part component vector of an edge weight vector, wherein
a weighted vector of the real part component of the input vector of the connection edge comprises an all-one matrix, and a weighted vector of the real part component of the edge weight vector comprises an all-one matrix; and
a weighted vector of the imaginary part component vector of the input vector of the connection edge comprises one of an all-one matrix or an all-zero matrix, and a weighted vector of the imaginary part component vector of the edge weight vector comprises one of an all-one matrix or an all-zero matrix.

12. The method of claim 4 or 8, wherein the digital predistortion filter module comprises an input layer and a complex inner product layer; and
a signal vector input to the input layer and a filter coefficient vector provided by the residual network module are processed in the complex inner product layer to obtain a digitally predistorted filtered signal scalar.

13. The method of claim 12, wherein a complex inner product comprises real part component vectors and imaginary part component vectors of two complex operation vectors, wherein
weighted vectors of the real part component vectors of the two complex operation vectors comprise an all-one matrix; and
weighted vectors of the imaginary part component vectors of the two complex operation vectors comprise one of an all-one matrix or an all-zero matrix.

14. The method of claim 1 or 3, wherein obtaining the artificial-intelligence-digital-predistortion schemes of the eight neural-networks by using the software configuration comprises:
obtaining the artificial-intelligence-digital-predistortion schemes of following eight neural-networks by using the software configuration: a complex WH residual network, a real WH residual network, a complex WH deep neural network, a real WH deep neural network, a complex residual network, a real residual network, a complex deep neural network, and a real deep neural network.

15. The method of claim 1 or 3, wherein obtaining the artificial-intelligence-digital-predistortion schemes of the eight neural-networks by using the software configuration comprises:
obtaining the artificial-intelligence-digital-predistortion schemes of the eight neural-networks by reconfiguring a fully connected weight matrix between an input layer of a WH module and a first hidden layer of the WH module and a fully connected weight matrix between the first hidden layer of the WH module and a second hidden layer of the WH module and reconfiguring a fully connected weight matrix of a hot link in a residual network module by using the software configuration.

16. The method of claim 15, wherein the fully connected weight matrix between the input layer and the first hidden layer and the fully connected weight matrix between the first hidden layer and the second hidden layer are configured in one of the following manners: identity matrix, random initialization, historical training weight initialization, or other constant weight initialization; and
the fully connected weight matrix of the hot link in the residual network module are configured in one of the following manners: all-zero matrix, random initialization, historical training weight initialization, or other constant weight initialization.

17. A device, comprising a memory and at least one processor, wherein
the memory is configured to store at least one program; and
the at least one processor is configured to perform the method of any one of claims 1 to 16 when executing the at least one program.

18. A storage medium storing a computer program which, when executed by a processor, causes the processor to perform the method of any one of claims 1 to 16.
